# EUROPÄISCHE PATENTANMELDUNG

(11) **EP 0 697 736 A2**
(43) Veröffentlichungstag der Anmeldung: **21.02.1996**
(21) Anmeldenummer: 95810473.9
(22) Anmeldetag: 20.07.1995
(51) Int. Cl.: H01L 29/06, H01L 29/74, H01L 29/08

(54) **MOS-gesteuertes Leistungshalbleiterbauelement für hohe Spannungen**

(30) Priorität: 08.08.1994 DE 4427988
(71) Anmelder: ABB Management AG, CH-5401 Baden (CH)
(72) Erfinder: Bauer, Friedhelm, Dr., CH-5034 Suhr (CH)

(57) **Zusammenfassung**

Bei einem MOS gesteuerten Leistungshalbleiterbauelement mit einer Vielzahl von Kathodenzellen wird der Flächenanteil der Kathodenzellen an der totalen Bauteilfläche bei zirkulärer Zellgeometrie zwischen 0.1% und 10%, bei streifenförmiger Zellgeometrie zwischen 0.4% und 40% gewählt. Dadurch kann die durch kleine Induktivitäten hervorgerufene Schwingungsneigung verringert werden.

## Beschreibung

### Technisches Gebiet

Die Erfindung bezieht sich auf das Gebiet der Leistungshalbleiterbauelemente. Sie geht aus von einem MOS gesteuerten Leistungshalbleiterbauelement nach dem Oberbegriff des ersten Anspruchs.

### Stand der Technik

Ein solches MOS gesteuertes Leistungshalbleiterbauelement wird beispielsweise schon in der Europäischen Patentanmeldung EP 0 528 349 A1 beschrieben. Es handelt sich dabei um einen IGBT mit einer hohen Durchbruchsspannung.

Derartige IGBTs oder ganz allgemein MOS gesteuerte Leistungshalbleiterbauelemente umfassen in einem Halbleitersubstrat zwischen einer Anode und einer Kathode eine Anzahl unterschiedlich dotierter Halbleiterschichten und auf der Kathodenseite eine Vielzahl parallelgeschalteter Einheitszellen oder Kathodenzellen. Diese Kathodenzellen weisen ein isoliert angeordnetes Gate auf, mittels welchem das Bauelement ein- und ausgeschaltet werden kann. Je nach Typ des Bauelements sind die Kathodenzellen und die Halbleiterschichten verschieden ausgeführt.

Auf der Anodenseite können verschiedene, anforderungsspezifische Strukturen vorgesehen werden. Für IGBTs können Beispiele dafür den Schriften "A Performance Trade-Off for the IGBT: Buffer Layer versus Base Lifetime Reduction" von A.R. Hefner et al., IEEE Trans. on Power Electronics, Vol. PE-2, No. 3, July 1987, und "A 2000V Non-punchtrough IGBT with High Ruggedness" von T. Laska et al., Solid State Electronics, Vol. 35, No. 5, pp. 681-685, 1992, entnommen werden.

Wie F. Bauer et al. in ihrem Beitrag zum International Symposium on Power Semiconductor Devices & ICs 1994 "On the Suitability of BiMOS High Power Devices in Intelligent Snubberless Power Conditioning Circuits", Proc. ISPSD, Davos 1994, Seite 201 ff., ausführen, neigen derartige Bauteile zu Schwingungen. Diese Schwingungen werden insbesondere durch ein Zusammenwirken der zur Begrenzung der Stromänderung dla/dt benötigten Emitterinduktivität mit der strukturinhärenten Gate-Kathodenkapazität hervorgerufen. Derartige Schwingungen beschränken die Leistungsfähigkeit des Bauteils erheblich und können die Lebensdauer gefährden.

Im oben erwähnten Artikel von F. Bauer et al. wurde die Schwingungsneigung vor allem anhand von MCTs untersucht. Weiterführende Versuche haben jedoch gezeigt, dass alle derzeit bekannten MOS gesteuerten Leistungshalbleiterbauelemente dieses Phänomen zeigen.

Der MCT wird im Artikel "MOS-Controlled Thyristors - A New Class of Power Devices" von V.A.K. Temple, in IEEE Transactions on Electron Devices, Vol. ED-33, No. 10, Oktober 1986, oder im Beitrag von F. Bauer "The MOS Controlled Thyristor and Its Limits", in Power Semiconductor Devices and Circuits, Edited by A.A. Jaecklin, Plenum Press, New York 1992, pp. 31-61, beschrieben. Der IGBT oder IGT wird von B.J. Baliga im "Evolution of MOS-Bipolar Power Semiconductor Technology", in Proceedings if the IEEE, Vol 76, No. 4, April 1988, beschrieben. Ein weiteres MOS gesteuertes Leistungshalbleiterbauelement ist der FiBS (Five Layer Bipolar Switch), von K. Lilija beschrieben in der US Patentschrift 5,289,981 und der Europäischen Patentanmeldung EP 0 487 869 A1, oder der IGTH oder BRT (BRT = Base Resistance Controlled Thyristor), von F. Bauer et al. beschrieben in der Deutschen Offenlegungsschrift, DE 40 24 526 A1. Alle aufgeführten Bauelemente neigen zu Schwingungen, welche die Leistungsfähigkeit und die Lebensdauer einschränken können.

### Darstellung der Erfindung

Aufgabe der vorliegenden Erfindung ist es, ein MOS gesteuertes Leistungshableiterbauelement anzugeben, bei welchem die oben erläuterte Schwingungsneigung nicht auftritt, welches preisgünstig und einfach herzustellen ist und zudem geringe Schaltverluste aufweist.

Diese Aufgabe wird bei einem MOS gesteuerten Leistungshalbleiterbauelement der eingangs genannten Art durch die Merkmale des ersten Anspruchs gelöst.

Kern der Erfindung ist es also, dass Kopplung von Anode und Kathode erhöht wird. Dies kann einerseits durch Einfügen einer externen Kapazität in der Grössenordnung von 1 nF/cm zwischen Gate und Anode geschehen oder dadurch, dass die Kathodenzellen bei zirkulärer Zellgeometrie zwischen 0.1% und 10% und bei streifenförmiger Zellgeometrie zwischen 0.4% und 40% der gesamten Bauelementfläche beanspruchen. Dies kann in einem bevorzugten Ausführungsbeispiel dadurch erreicht werden, dass der Zellabstand zwischen 25 µm und 250 µm gewählt wird. Besonders vorteilhaft ist ein Abstand zwischen 70 µm und 150 µm.

Weitere Ausführungsbeispiele ergeben sich durch die Struktur der Kathodenzellen. Sie werden in entsprechenden abhängigen Ansprüchen beschrieben.

Der Vorteil des erfindungsgemässen Aufbaus besteht darin, dass dadurch, dass der Flächenanteil der Einheits- oder Kathodenzellen relativ gering ist bzw. der Abstand zwischen zwei Zellen im Vergleich zum Stand der Technik gross gewählt wird, die Schwingungsneigung der Baueleder Technik gross gewählt wird, die Schwingungsneigung der Bauelemente im wesentlichen verschwindet. Dies ganz im Gegensatz zu den Bauelementen nach dem Stand der Technik, wo der Zellabstand viel geringer ist, siehe z.B. der eingangs erwähnte Aufsatz von A.R. Hefner et al., bei welchem der Zellabstand gerade 10 µm beträgt. Ausserdem erhält man den Effekt, dass die breiten Strukturen nach der Erfindung geringere Schaltverluste aufweisen. Damit erreicht man auch eine höhere Lebensdauer als beim Stand der Technik. Dies liegt vor allem daran, dass auf eine höher dotierte, sogenannte JFET-Zone zwischen und unter den Einheitszellen verzichtet werden kann. Dies bringt den Vorteil mit sich, dass ein Prozesschritt eingespart werden kann. Dadurch ist das Bauelement einfacher und billiger herzustellen. Dies vermindert seinerseits wieder die Ausschussrate und erhöht die Zuverlässigkeit aufgrund von kleineren Prozessfluktuationen. Ausserdem wird es möglich, die Beschaltung der Elemente zu reduzieren, da eine Emitterinduktivität zur dl/dt Begrenzung keine Schwingungen mehr verursacht und auf weitere Kompensationselemente verzichtet werden kann.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Einen Ausschnitt eines erfindungsgemässen Leistungshalbleiterbauelementes, bei welchem die Einheitszellen nur schematisch angedeutet sind;
- **Fig. 2a-d**: Verschiedene Arten von Einheitszellen.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

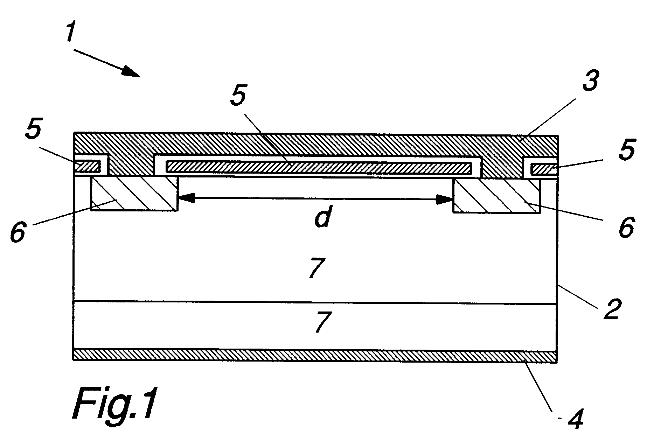

Figur 1 zeigt schematisch einen Ausschnitt eines erfindungsgemässen MOS gesteuerten Leistungshalbleiterbauelements. In einem Halbleitersubstrat 2 sind zwischen einer nur angedeuteten Kathode 3 und einer Anode 4 ein Anzahl unterschiedlich dotierter Halbleiterschichten 7 angeordnet. Von der kathodenseitigen Oberfläche her sind zudem eine Vielzahl von Kathodenzellen 6 in das Halbleitersubstrat 2 eingelassen. Über den Kathodenzellen 6 ist ein Gate 5 vorgesehen. Das Gate 5 ist von der Kathode 3 isoliert z.B. durch ein Oxidschicht (MOS-Anordnung). Durch Anlegen einer Spannung an das Gate 5 kann der Stromfluss durch das Bauelement 1 gesteuert, d.h. ein- und ausgeschaltet werden.

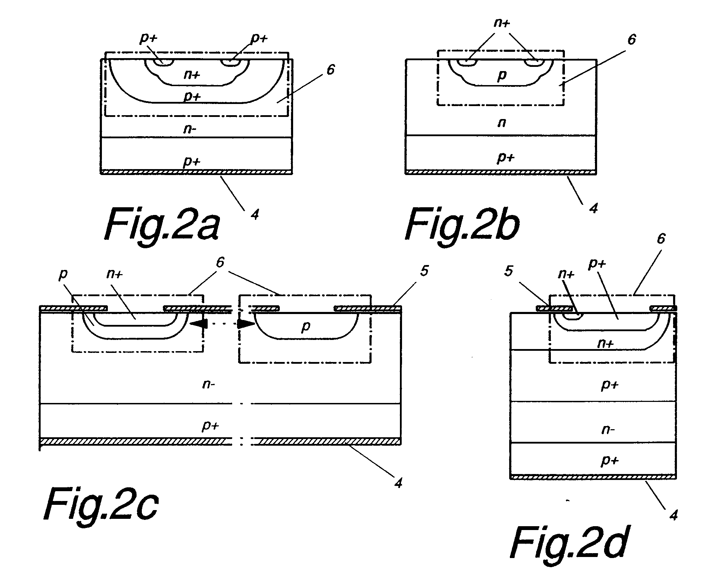

Die Funktionsweise solcher Leistungshalbleiterbauelemente ist aus dem eingangs genannten Stand der Technik bestens bekannt, so dass auf eine detaillierte Beschreibung an dieser Stelle verzichtet werden kann. Die Erfindung ist nicht auf eine spezielle Art von MOS gesteuerten Leistungshalbleiterbauelementen beschränkt, sondern sie wird mit Erfolg für alle in den Figuren 2a-d dargestellten Einheitszelltypen angewendet. Im einzelnen sind dies MCT (Figur 2a) mit einer Vierschicht-Struktur und p + dotierten Kurzschlüssen, IGBT (Figur 2b) mit einer Dreischicht-Struktur und n + dotierten Kurzschlüssen, IGTH oder BRT (Figur 2c) mit einer Dreischicht-Struktur und zwei Arten von Einheitszellen, von denen die eine nur eine p + Wanne und die andere zusätzlich eine n + dotierte Wanne umfasst, welche in die p + Wanne eingelassen ist, sowie ein FiBS (Field controlled Bipolar Switch) mit einer Fünfschichtstruktur und n + dotierten, MOS gesteuerten Sourcegebieten.

Bei allen derartigen Bauelementen wird versucht, mittels kleinen Induktivitäten die üblicherweise vorgesehene Freilaufdiode vor zu steilen Stromflanken dl/dt zu schützen. Im eingangs erwähnten Artikel des ISPSD '94 wurde jedoch erkannt, dass die Bauelemente unter anderem auf Grund dieser Induktivitäten zu Schwingungen neigen. Im folgenden wird die Problematik anhand eines IGBTs näher erläutert.

Bei diesem Bauelement werden die Induktivitäten am Emitter angeschlossen (Emitterinduktivitäten). Die Schwingungsneigung basiert im wesentlichen darauf, dass die an der Emitterinduktivität induzierte Spannung über die strukturinhärente Gate-Kathodenkapazität in den Gatekreis des IGBT zurückgekoppelt wird. Die Schwingungen werden nur durch Lawinenprozesse begrenzt und können mit grosser Wahrscheinlichkeit zur Zerstörung des Bauelements führen. Die Schwingungen können zudem bereits bei Induktivitätswerten auftreten, welche nur geringfügig grösser sind als typische Induktivitäten von Bonddrähten.

Um die Schwingungsneigung in der Anwendung zu verhindern, wird nun nach der Erfindung die Kopplung zwischen Anode und Kathode erhöht. Dies geschieht dadurch, dass die Gate-Anodenkapazität vergrössert wird. Erfindungsgemäss wird zu diesen Zweck der Abstand d zwischen zwei Kathodenzellen, im Gegensatz zum Stand der Technik, recht gross gewählt wird. Das Kriterium des Abstandes kann im allgemeinen Fall auch als Flächenanteil der Kathodenzellen an der totalen Bauelementfläche ausgedrückt werden.

Um die Schwingungsneigung wirksam zu vermeiden, soll der Anteil der Kathodenzellen an der gesamten Bauelementfläche bei kreisförmiger Zellgeometrie zwischen 0.1% und 10%, bei streifenförmiger Geometrie zwischen 0.4% und 40% betragen. Bei derzeit üblichen Bauelementen von 1-2 cm Durchmesser ergibt dies einen bevorzugten Abstand zwischen benachbarten Zellen zwischen 25µm und 250µm. Besonders bevorzugt werden aufgrund technologischer Vorteile Abstände zwischen 70µm und 150µm.

Auf der Anodenseite können selbstverständlich alle bekannten Massnahmen wie Anodenkurzschlüsse, Soft-Layer oder Stopschichten vorgesehen werden. Die Erfindung ist auch nicht auf den oben erläuterten IGBT beschränkt, sondern wird mit Vorteil bei allen MOS gesteuerten Leistungshalbleiterbauelementen verwendet.

Die Vorteile der erfindungsgemässen Wahl des Abstandes zweier Kathodenzellen bzw. des Flächenanteils der Kathodenzellen bestehen darin, dass die Schwingungsneigung, hervorgerufen durch kleine Induktivitäten, im wesentlichen verschwindet und somit ein preisgünstiger dl/dt-Schutz der Freilaufdioden ohne grosse Einschaltsnubber erreicht werden kann. Die breiten Strukturen weisen zudem eine geringe Empfindlichkeit gegenüber Prozessfluktuationen auf. Insbesondere können höher dotierte, sogenannte JFET-Zonen zwischen und unter den Einheitszellen weggelassen werden. Dadurch wird der Herstellungsprozess vereinfacht und damit billiger. Ausserdem bewirkt ein Verzicht auf die höher dotierten JFET-Zonen, dass im Inneren des Bauelements kleinere Feldstärken vorherrschen. Dadurch erhält man geringere Schaltverluste und die Lebensdauer der Bauelemente wird grösser.

Im Gegensatz zum Stand der Technik, wo man im unteren Spannungsbereich (bis ca. 600 V) zu immer kleineren Strukturen gehen muss, bringen also die erfindungsgemässen breiten Strukturen bei Hochspannungsbauelementen grosse und vielfältige Vorteile.

### Bezeichnungsliste

- 1: Leistungshalbleiterbauelement
- 2: Halbleitersubstrat
- 3: Kathode
- 4: Anode
- 5: Gate
- 6: Kathodenzellen
- 7: Halbleiterschichten
- d: Abstand zwischen zwei Kathodenzellen

## Patentansprüche

1. MOS gesteuertes Leistungshalbleiterbauelement (1) für hohe Spannungen umfassend in einem Halbleitersubstrat (2) zwischen einer Kathode (3) und einer Anode (4) eine Anzahl unterschiedlich dotierter Schichten (7) und eine Vielzahl von auf der Kathodenseite eingelassenen, mittels eines MOS-Gates (5) gesteuerten Kathodenzellen (6), dadurch gekennzeichnet, dass die Kathodenzellen (6) bei einer zirkulären Zellgeometrie zwischen 0.1% und 10%, bei einer streifenförmigen Zellgeometrie zwischen 0.4% und 40% der gesamten Bauelementfläche beanspruchen.

2. Leistungshalbleiterbauelement nach Anspruch 1, dadurch gekennzeichnet, dass ein lateraler Abstand d zwischen zwei benachbarten Zellen zwischen 25µm und 250µm beträgt.

3. Leistungshalbleiterbauelement nach Anspruch 2, dadurch gekennzeichnet, dass der laterale Abstand d zwischen 70µm und 150µm beträgt.

4. Leistungshalbleiterbauelement nach einem der Ansprüche 1-3, dadurch gekennzeichnet, dass die Kathodenzellen (6) die Struktur einer Einheitszelle eines MOS gesteuerten Thyristors (MCT) aufweisen.

5. Leistungshalbleiterbauelement nach einem der Ansprüche 1-3, dadurch gekennzeichnet, dass die Kathodenzellen (6) die Struktur einer Einheitszelle eines bipolaren Transistors mit isoliertem Gate (IGBT) aufweisen.

6. Leistungshalbleiterbauelement nach einem der Ansprüche 1-3, dadurch gekennzeichnet, dass das Halbleitersubstrat (2) von der Anode her eine stark p-dotierte Schicht und eine schwach n-dotierte Schicht sowie zwei Arten von Einheitszellen umfasst, welche durch eine in die schwach n-dotierte Schicht eingelassene stark p-dotierte Wanne gebildet werden, wobei die eine Art Einheitszellen zusätzlich eine stark n-dotierte Wanne umfasst, welche in die p-Wanne eingelassen ist.

7. Leistungshalbleiterbauelement nach einem der Ansprüche 1-3, dadurch gekennzeichnet, dass das Halbleitersubstrat eine 5-Schicht-Struktur umfasst und die Einheitszellen durch eine stark p-dotierte Wanne gebildet werden, in welche ein stark n-dotiertes Sourcegebiet eingelassen ist.
